# EUROPÄISCHE PATENTSCHRIFT

(11) **EP 3 224 630 B1**
(45) Veröffentlichungstag und Bekanntmachung des Hinweises auf die Patenterteilung: **01.12.2021**
(21) Anmeldenummer: 16700536.2
(22) Anmeldetag: 07.01.2016
(51) Int. Cl.: G01R 31/14, G01R 31/62, H02M 1/00, G01R 31/327

(54) **SCHALTUNGSANORDNUNG FÜR HOCHSPANNUNGSPRÜFUNGEN UND HOCHSPANNUNGSPRÜFANLAGE**
CIRCUIT ASSEMBLY FOR HIGH-VOLTAGE TESTS AND HIGH-VOLTAGE TESTING SYSTEM
AGENCEMENT DE CIRCUIT POUR TESTS À HAUTE TENSION ET SYSTÈME DE TESTS À HAUTE TENSION

(30) Priorität: 21.01.2015 DE 102015200902
(43) Veröffentlichungstag der Anmeldung: 04.10.2017
(73) Patentinhaber: Siemens Energy Global GmbH & Co. KG, 81739 München (DE)
(72) Erfinder: BOCK, Markus, 96047 Bamberg (DE)
(86) Internationale Anmeldenummer: PCT/EP2016/050155
(87) Internationale Veröffentlichungsnummer: WO 2016/116293

(56) Entgegenhaltungen:
- EP-A2- 2 765 429
- WO-A1-2011/157046
- US-A- 5 396 172
- US-A1- 2013 176 046
- US-A1- 2014 125 351
- "The MTC3-Class - MTC3 Stator Testers", , 1. Juni 2013 (2013-06-01), Seiten 92-133, XP055267466, Gefunden im Internet: URL:http://www.schleich.com/admin/pic/prod uktpdf/589-Katalog_6_MTC3_Klasse_en.pdf [gefunden am 2016-04-21]
- HIGHVOLT PRÜFTECHNIK DRESDEN GMBH: "On-site Transformer Test Systems for Induced Voltage Testing no-load / load losses Testing (Doc.No.8.71/1)", INTERNET CITATION, 17. Oktober 2008 (2008-10-17), XP007906010, Gefunden im Internet: URL:http://www.highvolt.de/datasheets/8-71 -1.pdf?PHPSESSID=6486e9de4b163efa7066be032 d6470cd [gefunden am 2008-10-17]

## Beschreibung

Die Erfindung betrifft eine Schaltungsanordnung für Hochspannungsprüfungen und eine Hochspannungsprüfanlage.

Die vollständige Hochspannungsprüfung von Hochspannungsprodukten erfordert unter anderem Wechselspannungs- und/oder Gleichspannungs- sowie Stoßspannungsprüfungen. Am häufigsten werden Wechselspannungsprüfungen eingesetzt, als Stück- und/oder Typprüfung für Wechselspannungsprodukte. In zunehmendem Maße werden jedoch auch Gleichspannungsprüfungen benötigt werden, als Stück- und/oder Typprüfung für den wachsenden Markt von Gleichspannungsprodukten.

Stoßspannungsprüfungen werden zusätzlich für die Prüfung beider Produktkategorien, d. h. von Gleichspannungsprodukten und von Wechselspannungsprodukten, benötigt. Gefordert sind dabei zwei Arten von Stoßspannungsprüfungen: so genannte Schaltstoß- und Blitzstoßprüfungen. Eine Schaltstoßprüfung ist aus technischer Sicht in der Regel als Sonderprüfung bzw. Typprüfung ausreichend und wird üblicherweise auch als solche praktiziert. Die Anzahl abzuarbeitender Schaltstoßprüfungen ist daher in der Praxis relativ gering. Blitzstoßprüfungen sind dagegen aus technischer Sicht nicht nur als Sonder- bzw. Typprüfungen sinnvoll, sondern, insbesondere bei gasisolierten Produkten, auch als Stückprüfungen. Zwar werden Blitzstoßstückprüfungen gegenwärtig wegen des zusätzlich nötigen Aufwandes relativ selten ausgeführt, jedoch nimmt die Nachfrage nach Blitzstoßstückprüfungen ständig zu.

Üblicherweise werden Wechselspannungs-, Gleichspannungs- und Stoßspannungsprüfungen getrennt voneinander an drei separaten Prüfanlagen durchgeführt. Dies verursacht im Prüffeld einen relativ großen Platz- und Investitionsbedarf für mehrere Prüfanlagen und einen entsprechenden Aufwand, um einen Prüfling zwischen den verschiedenen Prüfanlagen zu transportieren. Bei Vorort-Prüfungen entsteht zudem Aufwand für den Versand mehrerer Anlagen. Besonders groß ist der Aufwand bei der Prüfung gasisolierter Produkte, z. B. gasisolierter Schaltanlagen. Derartige Produkte werden vorzugsweise direkt (ohne eine Luftdurchführung) an eine Prüfanlage angeflanscht, um den Platzbedarf für große Isolierabstände in Luft zu reduzieren und gute Teilentladungsstörpegel zu erreichen. Für Wechselspannungsprüfungen ist dies mit verfügbaren Prüfanlagen möglich. Für Blitzstoß- und Gleichspannungsprüfungen dagegen erfordert dies in der Regel einen Umbau von Prüfanlagen mit Luftprüfdurchführungen.

Relevanter Stand der Technik findet sich in den Dokumenten US 2014/125351 A1, "The MTC3-Class - MTC3 Stator Testers" (XP055267466), WO 2011/157046 A1, EP 2 765 429 A2, US 5 396 172 A, US 2013/176046 A1 und "On-site Transformer Test Systems for Induced Voltage Testing no-load / load losses Testing (Doc.No.8.71/1)"(XP007906010).

Der Erfindung liegt die Aufgabe zugrunde, eine verbesserte Schaltungsanordnung für Hochspannungsprüfungen anzugeben. Die Aufgabe wird erfindungsgemäß durch die Merkmale des Anspruchs 1 gelöst.

Vorteilhafte Ausgestaltungen der Erfindung sind Gegenstand der Unteransprüche.

Eine erfindungsgemäße Schaltungsanordnung für Hochspannungsprüfungen umfasst eine Wechselspannungsquelle und wenigstens zwei Schaltungszweige, die jeweils mit der Wechselspannungsquelle elektrisch verbindbar sind. Dabei ist mittels eines ersten Schaltungszweiges eine elektrische Wechselspannung an einen Prüfling anlegbar, und mittels eines eine Wechselspannung gleichrichtenden zweiten Schaltungszweiges ist eine elektrische Gleichspannung an den Prüfling anlegbar.

Eine derartige Schaltungsanordnung ermöglicht vorteilhaft die Realisierung einer Hochspannungsprüfanlage, mit der wahlweise Wechsel- und/oder Gleichspannungsprüfungen eines Prüflings durchgeführt werden können, ohne die Position des Prüflings ändern zu müssen. Durch eine geeignete Ausbildung des zweiten Schaltungszweiges (siehe unten) sind darüber hinaus auch Stoßspannungsprüfungen realisierbar, so dass an einer einzigen Hochspannungsprüfanlage alle drei Hochspannungsprüfungsarten (Wechsel-, Gleich- und Stoßspannungsprüfungen) platzsparend und kostengünstig durchgeführt werden können.

Die erfindungsgemäße Schaltungsanordnung sieht weiterhin einen ersten Schalter, über den der erste Schaltungszweig mit der Wechselspannungsquelle elektrisch verbindbar ist, und einen zweiten Schalter, über den der zweite Schaltungszweig mit der Wechselspannungsquelle elektrisch verbindbar ist, vor.

Derartige Schalter ermöglichen vorteilhaft in besonders einfacher Weise, wahlweise eine Gleichspannung und/oder Wechselspannung an einen Prüfling anzulegen.

Eine Ausgestaltung der Erfindung sieht vor, dass die Wechselspannungsquelle einen regelbaren Transformator zur Erzeugung von Wechselspannungen variabler Effektivwerte aufweist.

Dadurch können vorteilhaft die mittels des ersten Schaltungszweiges an den Prüfling anlegbaren Wechselspannungen und die mittels des zweiten Schaltungszweiges an den Prüfling anlegbaren Gleichspannungen dem Prüfling und den Prüfungserfordernissen angepasst werden. Insbesondere sieht die Erfindung Wechselspannungsquellen vor, mittels derer Wechselspannungen relativ hoher Effektivwerte bis zu beispielsweise 750 kV erzeugt werden können. Dadurch werden in den beiden Schaltungszweigen keine oder relativ moderate Mittel zur Erzeugung ausreichend hoher Wechsel- und Gleichspannungen sowie aus den Gleichspannungen erzeugter Stoßspannungen für übliche Hochspannungsprüfungen benötigt, so dass insbesondere Kosten und Aufwand für eine Spannungsvervielfachung in den Schaltungszweigen entfallen.

Eine weitere Ausgestaltung der Erfindung sieht wenigstens eine Stoßspannungsgeneratorstufe zur Erzeugung eines an einen Prüfling anlegbaren Hochspannungsimpulses vor, wobei die Stoßspannungsgeneratorstufe einen Speicherkondensator und eine Funkenstrecke zur Entladung des Speicherkondensators aufweist.

Diese Ausgestaltung der Erfindung ermöglicht vorteilhaft die Erzeugung von Hochspannungsimpulsen durch Aufladung wenigstens eines Speicherkondensators und dessen Entladung über wenigstens eine Funkenstrecke.

Vorzugsweise weist die Schaltungsanordnung dabei wenigstens zwei in Reihe geschaltete Stoßspannungsgeneratorstufen auf.

Dies ermöglicht vorteilhaft eine Erhöhung der Spannungen der Hochspannungsimpulse durch eine Kopplung mehrerer Stoßspannungsgeneratorstufen.

Vorzugsweise weist dabei eine erste Stoßspannungsgeneratorstufe eine aktiv zündbare erste Funkenstrecke auf.

Dies ermöglicht vorteilhaft eine sichere und zeitlich steuerbare Erzeugung von Hochspannungsimpulsen durch eine aktive Zündung der Funkenstrecke einer Stoßspannungsgeneratorstufe.

Ferner umfasst eine mit wenigstens einer Stoßspannungsgeneratorstufe ausgeführte Schaltungsanordnung vorzugsweise eine parallel zu dem Prüfling geschaltete Abschneidefunkenstrecke. Dabei ist die Abschneidefunkenstrecke vorzugsweise aktiv auslösbar, d. h. aktiv zündbar, ausgebildet.

Dies ermöglicht vorteilhaft die Erzeugung einer Sonderform von Blitzstoßspannungen mit abgeschnittenen Spannungswellen. Eine besonders bevorzugte Ausgestaltung der Erfindung sieht vor, dass die wenigstens eine Stoßspannungsgeneratorstufe in den zweiten Schaltungszweig integriert ist.

Diese Ausgestaltung ermöglicht vorteilhaft eine besonders effiziente und platzsparende Ausführung einer Hochspannungsprüfanlage, mit der wahlweise Wechsel-, Gleich- und/oder Stoßspannungsprüfungen realisiert werden können, indem die Gleichspannung des zweiten Schaltungszweiges auch zur Erzeugung von Stoßspannungen verwendet wird.

Weitere Ausgestaltungen einer Schaltungsanordnung mit wenigstens einer Stoßspannungsgeneratorstufe sehen vor, dass wenigstens eine Stoßspannungsgeneratorstufe eine Funkenstrecke mit Funkenstreckenelektroden, deren Elektrodenabstand bis zu einer Berührung der Funkenstreckenelektroden verstellbar ist, aufweist, und/oder dass die Funkenstrecke wenigstens einer Stoßspannungsgeneratorstufe durch eine Überbrückungsleitung und einen Überbrückungsschalter überbrückbar ist.

Diese Ausgestaltungen ermöglichen vorteilhaft, Funkenstrecken erforderlichenfalls kurzzuschließen, beispielsweise, um mittels des zweiten Schaltungszweiges eine reine Gleichspannungsprüfung ohne Stoßspannungen zu realisieren, und/oder um aus Sicherheitsgründen eine Kondensatorentladung nach Betriebsschluss durchzuführen.

Eine weitere Ausgestaltung der Erfindung sieht vor, dass der erste Schaltungszweig für Teilentladungsmessungen einen Koppelkondensator und einen diesem nachgeschalteten ersten Auskoppelvierpol umfasst.

Diese Ausgestaltung der Erfindung ermöglicht vorteilhaft, mittels des ersten Schaltungszweiges auch Wechselstrom-Teilentladungsmessungen durchzuführen.

Eine weitere Ausgestaltung der Erfindung sieht vor, dass der zweite Schaltungszweig zur Erhöhung der Gleichspannung ein Villard-Schaltungsglied mit einem Villard-Ladekondensator und einer Villard-Diode umfasst.

Diese Ausgestaltung der Erfindung ermöglicht vorteilhaft, die Gleichspannung im zweiten Schaltungszweig durch eine so genannte Villard-Schaltung zu erhöhen.

Dabei weist der zweite Schaltungszweig für Teilentladungsmessungen vorzugsweise einen zweiten Auskoppelvierpol, der über einen Auskoppelschalter mit dem Villard-Ladekondensator verbindbar ist, auf.

Diese Weiterbildung der vorgenannten Ausgestaltung der Erfindung ermöglicht vorteilhaft, eine Teilentladungsmessung im Gleichspannungsbetrieb mittels des zweiten Schaltungszweiges durchzuführen.

Eine erfindungsgemäße Hochspannungsprüfanlage weist eine erfindungsgemäße Schaltungsanordnung für Hochspannungsprüfungen mit den oben bereits genannten Vorteilen auf.

Vorzugsweise ist die Schaltungsanordnung dabei in einem zur Befüllung mit einem Isoliergas ausgebildeten Gehäuse, das einen Anschlussflansch für einen Prüfling aufweist, angeordnet.

Dies ermöglicht vorteilhaft die Hochspannungsprüfung gasisolierter Produkte, z. B. gasisolierter Schaltanlagen, für Wechsel-, Gleich- und/oder Stoßspannungsprüfungen an dem Anschlussflansch, ohne einen Prüfling neu montieren zu müssen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan einer Schaltungsanordnung für Hochspannungsprüfungen und
- FIG 2: schematisch eine Hochspannungsprüfanlage für Hochspannungsprüfungen.

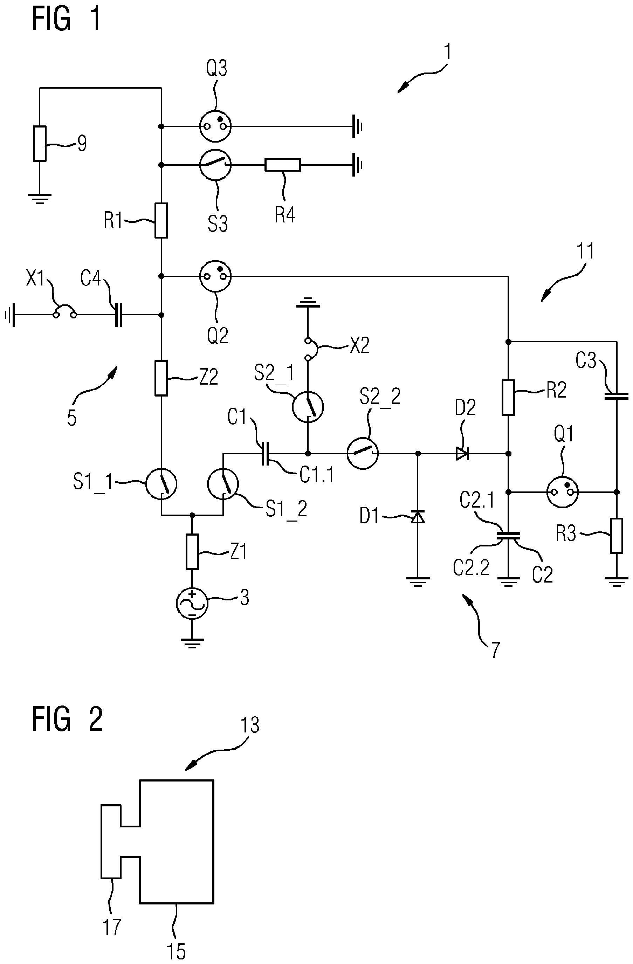

Figur 1 zeigt einen Schaltplan einer Schaltungsanordnung 1 einer in Figur 1 nicht dargestellten Hochspannungsprüfanlage 13 für Hochspannungsprüfungen, wobei verschiedene Komponenten der dargestellten Schaltungsanordnung 1 optional sind, wie im Folgenden ausgeführt wird.

Die Schaltungsanordnung 1 umfasst eine Wechselspannungsquelle 3, einen ersten Schaltungszweig 5, der über einen ersten Schalter S1_1 mit der Wechselspannungsquelle 3 elektrisch verbindbar ist, und einen zweiten Schaltungszweig 7, der über einen zweiten Schalter S1_2 mit der Wechselspannungsquelle 3 elektrisch verbindbar ist. Die Schalter S1_1, S1_2 können auch gemeinsam als ein Umschalter ausgeführt sein.

Die Wechselspannungsquelle 3 umfasst vorzugsweise einen regelbaren Transformator zur Erzeugung vergleichsweise hoher Wechselspannungen, beispielsweise von Wechselspannungen mit Effektivwerten von bis zu 750 kV.

Mittels des ersten Schaltungszweiges 5 ist eine elektrische Wechselspannung an einen Prüfling 9 anlegbar.

Optional umfasst der erste Schaltungszweig 5 für Wechselstrom-Teilentladungsmessungen einen Koppelkondensator C4 und einen diesem nachgeschalteten ersten Auskoppelvierpol X1.

Mittels des zweiten Schaltungszweiges 7 ist eine elektrische Gleichspannung an den Prüfling 9 anlegbar. Dazu umfasst der zweite Schaltungszweig 7 eine Einweggleichrichterstufe, die aus einer Gleichrichterdiode D2 und einem ersten Speicherkondensator C2 besteht. Die Gleichrichterdiode D2 ist zwischen den zweiten Schalter S1_2 und den Prüfling 9 geschaltet. Eine erste Elektrode C2.1 des ersten Speicherkondensators C2 ist mit dem prüflingsseitigem Pol der Gleichrichterdiode D2 verbunden, die zweite Elektrode C2.2 ist mit einer Signalmasse verbunden.

Optional umfasst der zweite Schaltungszweig 7 zur Erhöhung der Gleichspannung ferner ein Villard-Schaltungsglied mit einem Villard-Ladekondensator C1 und einer Villard-Diode D1. Der Villard-Ladekondensator C1 ist dabei zwischen den zweiten Schalter S1_2 und die Gleichrichterdiode D2 geschaltet. Die Villard-Diode D1 ist zwischen die Signalmasse und eine mit der Gleichrichterdiode D2 verbundene erste Elektrode C1.1 des Villard-Ladekondensators C1 geschaltet, so dass der Villard-Ladekondensator C1, die Villard-Diode D1, die Gleichrichterdiode D2 und der erste Speicherkondensator C2 eine Greinacher-Schaltung zur Spannungserhöhung bilden.

In der Ausführung mit dem Villard-Ladekondensator C1 und der Villard-Diode D1 umfasst der zweite Schaltungszweig 7 ferner optional einen Unterbrechungsschalter S2_2, mittels dessen zur Erhöhung der Betriebssicherheit eine elektrische Verbindung des Villard-Ladekondensators C1 mit der Villard-Diode D1 und der Gleichrichterdiode D2 unterbrochen werden kann, und/oder für Teilentladungsmessungen einen zweiten Auskoppelvierpol X2, der über einen Auskoppelschalter S2_1 mit der ersten Elektrode C1.1 des Villard-Ladekondensators C1 verbindbar ist, so dass eine Teilentladungsmessung auch im Gleichspannungsbetrieb durchführbar ist. Die Einspeisung von Teilentladungs-Kalibriersignalen kann in bekannter Weise über eine Schiebestab erfolgen. Ferner kann hinter dem zweiten Schalter S1_2 optional ein hier nicht dargestellter Erdungsschieber für den Villard-Ladekondensator C1 vorgesehen sein.

Für eine Umpolung der Gleichspannung im zweiten Schaltungszweig 7 kann eine Ausführung von bekannten Dioden-Bauweisen erfolgen, beispielsweise ein segmentierter Aufbau und eine mechanische Wippschaltung oder Drehschaltung der Segmente. Bei der Ausführung mit dem Villard-Ladekondensator C1 und der Villard-Diode D1 erfolgt die Anordnung beider Dioden D1, D2 vorzugsweise geometrisch linear zueinander, um die Umpolmechaniken beider Dioden D1, D2 einfach koppeln zu können.

Ein besonders bevorzugtes Ausführungsbeispiel sieht vor, dass in den zweiten Schaltungszweig 7 eine Stoßgeneratorschaltung 11 mit mehreren in Reihe geschalteten Stoßspannungsgeneratorstufen zur Erzeugung eines an den Prüfling 9 anlegbaren Hochspannungsimpulses nach Prinzip eines so genannten Marx-Generators integriert ist. Im dargestellten Ausführungsbeispiel umfasst die Stoßgeneratorschaltung 11 zwei in Reihe geschaltete Stoßspannungsgeneratorstufen, die von zwei Funkenstrecken Q1, Q2, dem ersten Speicherkondensator C2, einem zweiten Speicherkondensator C3 und zwei Entladewiderständen R2, R3 gebildet werden.

Dabei umfasst eine erste Stoßspannungsgeneratorstufe eine aktiv zündbare erste Funkenstrecke Q1 zur Entladung des ersten Speicherkondensators C2. Die zweite Stoßspannungsgeneratorstufe umfasst die zweite Funkenstrecke Q2 zur Entladung des zweiten Speicherkondensators C3. Die beiden Speicherkondensatoren C2, C3 sind über die erste Funkenstrecke Q1 in Reihe geschaltet. Die zweite Funkenstrecke Q2 ist zwischen den zweiten Speicherkondensator C3 und den Prüfling 9 geschaltet, so dass eine Entladung des ersten Speicherkondensators C2 über die erste Funkenstrecke Q1 die am zweiten Speicherkondensator C3 anliegende Spannung erhöht, wodurch die zweite Funkenstrecke Q2 gezündet und ein Hochspannungsimpuls auf den Prüfling 9 übertragen wird.

Optional kann ein zwischen den Prüfling 9 und die Signalmasse geschalteter dritter Entladewiderstand R4 vorgesehen sein, der mit einem ihm vor- oder nachgeschalteten Zusatzschalter S3 zuschaltbar ist. Der dritte Entladewiderstand R4 kann entfallen, wenn der erste Entladewiderstand R2 und der zweite Entladewiderstand R3 zur Entladung bei gezündeten Funkenstrecken Q1, Q2 ausreichen.

Ferner kann optional eine zwischen den Prüfling 9 und die Signalmasse geschaltete Abschneidefunkenstrecke Q3 zur Erzeugung einer Sonderform einer Blitzstoßspannung mit einer abgeschnittenen Spannungswelle vorgesehen sein. Die Abschneidefunkenstrecke Q3 ist vorzugsweise aktiv auslösbar ausgebildet.

Zur Durchführung von Gleichspannungsprüfungen ohne einen mittels der Stoßgeneratorschaltung 11 erzeugten Hochspannungsimpulses ist die zweite Funkenstrecke Q2 durch eine Überbrückungsleitung und einen Überbrückungsschalter, die hier nicht dargestellt sind, überbrückbar oder ein Elektrodenabstand der Funkenstreckenelektroden der zweiten Funkenstrecke Q2 ist bis zu einer Berührung der Funkenstreckenelektroden verstellbar.

Optional ist ferner aus Sicherheitsgründen zur Kondensatorentladung nach Betriebsschluss, und/oder zur Vermeidung des Zündens der ersten Funkenstrecke Q1 bei einer reinen Gleichspannungsprüfung ohne Hochspannungsimpuls, ein Elektrodenabstand der Funkenstreckenelektroden der ersten Funkenstrecke Q1 bis zu einer Berührung der Funkenstreckenelektroden verstellbar ausgeführt.

Beide Schaltungszweige 5, 7 sind über einen Vorwiderstand R1 mit dem Prüfling 9 verbunden. Der Vorwiderstand R1 dient als Schutzwiderstand zur Vermeidung von Schäden an der Hochspannungsprüfanlage 13, insbesondere durch Spannungsspitzen, und im Falle einer Ausführung mit einer Stoßgeneratorschaltung 11 als ein zusätzlicher Ladewiderstand für die Stoßgeneratorschaltung 11. Für höhere Schutzauslegungen kann optional eine zwischen die Wechselspannungsquelle 3 und die Schalter S1_1, S1_2 geschaltete erste Impedanz Z1 und/oder eine im ersten Schaltungszweig 5 zwischen den ersten Schalter S1_1 und den Prüfling 9 geschaltete zweite Impedanz Z2 vorgesehen sein.

Für eine reine Wechselspannungsprüfung des Prüflings 9 werden der erste Schalter S1_1 geschlossen und der zweite Schalter S1_2 geöffnet.

Für eine Gleichspannungsprüfung des Prüflings 9 werden der erste Schalter S1_1 geöffnet und der zweite Schalter S1_2 geschlossen. Wenn die Gleichspannungsprüfung im Falle einer Ausführung mit einer Stoßgeneratorschaltung 11 ohne einen durch die Stoßgeneratorschaltung 11 erzeugten Hochspannungsimpuls durchgeführt werden soll, wird ferner das Zünden der ersten Funkenstrecke Q1 durch eine geeignete Einstellung von Parametern der ersten Funkenstrecke Q1, beispielsweise eines Drucks und/oder eines Elektrodenabstands, sicher vermieden, und die zweite Funkenstrecke Q2 wird entweder überbrückt oder die Funkenstreckenelektroden der zweiten Funkenstrecke Q2 werden miteinander in Berührung gebracht.

Für eine Stoßspannungsprüfung des Prüflings 9 werden der erste Schalter S1_1 geöffnet und der zweite Schalter S1_2 geschlossen, und es wird ein Hochspannungsimpuls durch aktives Auslösen (Zünden) der ersten Funkenstrecke Q1 erzeugt.

Für eine Wechselspannungsprüfung mit einer dieser überlagerten Stoßspannungsprüfung des Prüflings 9 werden beide Schalter S1_1, S1_2 geschlossen, und es wird ein Hochspannungsimpuls durch aktives Auslösen (Zünden) der ersten Funkenstrecke Q1 erzeugt.

Figur 2 zeigt rein schematisch eine Hochspannungsprüfanlage 13 mit einer in Figur 2 nicht sichtbaren Schaltungsanordnung 1 für Hochspannungsprüfungen. Die Schaltungsanordnung 1 ist in einem zur Befüllung mit einem Isoliergas, beispielsweise mit Schwefelhexafluorid, ausgebildeten Gehäuse 15, das einen Anschlussflansch 17 für einen Prüfling 9 aufweist, angeordnet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schaltungsanordnung (1) für Hochspannungsprüfungen, umfassend
- eine Wechselspannungsquelle (3)
- und wenigstens zwei Schaltungszweige (5, 7), die jeweils mit der Wechselspannungsquelle (3) elektrisch verbindbar sind,
- wobei mittels eines ersten Schaltungszweiges (5) eine elektrische Wechselspannung an einen Prüfling (9) anlegbar ist,
**dadurch gekennzeichnet, dass** mittels eines eine Wechselspannung gleichrichtenden zweiten Schaltungszweiges (7) eine elektrische Gleichspannung an den Prüfling (9) anlegbar ist, und die Schaltungsanordnung weiterhin einen ersten Schalter (S1_1), über den der erste Schaltungszweig (5) mit der Wechselspannungsquelle (3) elektrisch verbindbar ist, und einen zweiten Schalter (S1_2), über den der zweite Schaltungszweig (7) mit der Wechselspannungsquelle (3) elektrisch verbindbar ist, umfasst.

2. Schaltungsanordnung (1) nach einem der vorhergehenden Ansprüche,
**dadurch gekennzeichnet, dass** die Wechselspannungsquelle (3) einen regelbaren Transformator zur Erzeugung von Wechselspannungen verschiedener Effektivwerte aufweist.

3. Schaltungsanordnung (1) nach einem der vorhergehenden Ansprüche,
**gekennzeichnet durch**
wenigstens eine Stoßspannungsgeneratorstufe zur Erzeugung eines an einen Prüfling (9) anlegbaren Hochspannungsimpulses, wobei die Stoßspannungsgeneratorstufe einen Speicherkondensator (C2, C3) und eine Funkenstrecke (Q1, Q2) zur Entladung des Speicherkondensators (C2, C3) aufweist.

4. Schaltungsanordnung (1) nach Anspruch 3,
**gekennzeichnet durch**
wenigstens zwei in Reihe geschaltete Stoßspannungsgeneratorstufen.

5. Schaltungsanordnung (1) nach Anspruch 3 oder 4,
**dadurch gekennzeichnet, dass**
eine erste Stoßspannungsgeneratorstufe eine aktiv zündbare erste Funkenstrecke (Q1) aufweist.

6. Schaltungsanordnung (1) nach einem der Ansprüche 3 bis 5, **gekennzeichnet durch**
eine parallel zu dem Prüfling (9) geschaltete Abschneidefunkenstrecke (Q3).

7. Schaltungsanordnung (1) nach Anspruch 6,
**dadurch gekennzeichnet, dass**
die Abschneidefunkenstrecke (Q3) aktiv auslösbar ausgebildet ist.

8. Schaltungsanordnung (1) nach einem der Ansprüche 3 bis 7, **dadurch gekennzeichnet, dass**
die wenigstens eine Stoßspannungsgeneratorstufe in den zweiten Schaltungszweig (7) integriert ist.

9. Schaltungsanordnung (1) nach einem der Ansprüche 3 bis 8, **dadurch gekennzeichnet, dass** wenigstens eine Stoßspannungsgeneratorstufe eine Funkenstrecke (Q1, Q2) mit Funkenstreckenelektroden, deren Elektrodenabstand bis zu einer Berührung der Funkenstreckenelektroden verstellbar ist, aufweist, und/oder dass die Funkenstrecke (Q1, Q2) wenigstens einer Stoßspannungsgeneratorstufe durch eine Überbrückungsleitung und einen Überbrückungsschalter überbrückbar ist.

10. Schaltungsanordnung (1) nach einem der vorhergehenden Ansprüche,
**dadurch gekennzeichnet, dass**
der erste Schaltungszweig (5) für Teilentladungsmessungen einen Koppelkondensator (C4) und einen diesem nachgeschalteten ersten Auskoppelvierpol (X1) umfasst.

11. Schaltungsanordnung (1) nach einem der vorhergehenden Ansprüche,
**dadurch gekennzeichnet, dass**
der zweite Schaltungszweig (7) zur Erhöhung der Gleichspannung ein Villard-Schaltungsglied mit einem Villard-Ladekondensator (C1) und einer Villard-Diode (D1) umfasst.

12. Schaltungsanordnung (1) nach Anspruch 11,
**dadurch gekennzeichnet, dass**
der zweite Schaltungszweig (7) für Teilentladungsmessungen einen zweiten Auskoppelvierpol (X2), der über einen Auskoppelschalter (S2_1) mit dem Villard-Ladekondensator (C1) verbindbar ist, aufweist.

13. Hochspannungsprüfanlage (13) mit einer Schaltungsanordnung (1) nach einem der vorhergehenden Ansprüche für Hochspannungsprüfungen.

14. Hochspannungsprüfanlage (13) nach Anspruch 13,
**dadurch gekennzeichnet, dass**
die Schaltungsanordnung (1) in einem zur Befüllung mit einem Isoliergas ausgebildeten Gehäuse (15), das einen Anschlussflansch (17) für einen Prüfling (9) aufweist, angeordnet ist.

## Claims

1. Circuit arrangement (1) for high-voltage tests, comprising
- an AC voltage source (3)
- and at least two circuit branches (5, 7) which can each be electrically connected to the AC voltage source (3),
- an electrical AC voltage being able to be applied to a test object (9) by means of a first circuit branch (5),
**characterized in that**
an electrical DC voltage can be applied to the test object (9) by means of a second circuit branch (7) which rectifies an AC voltage,
and the circuit arrangement also comprises
a first switch (S1_1) which can be used to electrically connect the first circuit branch (5) to the AC voltage source (3), and a second switch (S1_2) which can be used to electrically connect the second circuit branch (7) to the AC voltage source (3) .

2. Circuit arrangement (1) according to the preceding claim, **characterized in that**
the AC voltage source (3) has a controllable transformer for producing AC voltages of different root mean square values.

3. Circuit arrangement (1) according to one of the preceding claims,
**characterized by**
at least one impulse voltage generator stage for producing a high-voltage pulse which can be applied to a test object (9), the impulse voltage generator stage having a storage capacitor (C2, C3) and a spark gap (Q1, Q2) for discharging the storage capacitor (C2, C3).

4. Circuit arrangement (1) according to Claim 3,
**characterized by**
at least two impulse voltage generator stages connected in series.

5. Circuit arrangement (1) according to Claim 3 or 4, **characterized in that**
a first impulse voltage generator stage has an actively triggerable first spark gap (Q1).

6. Circuit arrangement (1) according to one of Claims 3 to 5, **characterized by**
a chopping gap (Q3) connected in parallel with the test object (9) .

7. Circuit arrangement (1) according to Claim 6,
**characterized in that**
the chopping gap (Q3) is actively triggerable.

8. Circuit arrangement (1) according to one of Claims 3 to 7, **characterized in that**
the at least one impulse voltage generator stage is integrated in the second circuit branch (7).

9. Circuit arrangement (1) according to one of Claims 3 to 8, **characterized in that**
at least one impulse voltage generator stage has a spark gap (Q1, Q2) having spark gap electrodes, the electrode spacing of which can be adjusted until the spark gap electrodes touch, and/or **in that** the spark gap (Q1, Q2) of at least one impulse voltage generator stage can be bridged by means of a bypass line and a bypass switch.

10. Circuit arrangement (1) according to one of the preceding claims,
**characterized in that**
the first circuit branch (5) comprises, for partial discharge measurements, a coupling capacitor (C4) and a first decoupling four-terminal network (X1) connected downstream of the latter.

11. Circuit arrangement (1) according to one of the preceding claims,
**characterized in that**
the second circuit branch (7) comprises a Villard circuit element having a Villard charging capacitor (C1) and a Villard diode (D1) for increasing the DC voltage.

12. Circuit arrangement (1) according to Claim 11,
**characterized in that**
the second circuit branch (7) has, for partial discharge measurements, a second decoupling four-terminal network (X2) which can be connected to the Villard charging capacitor (C1) via a decoupling switch (S2_1).

13. High-voltage testing system (13) having a circuit arrangement (1) according to one of the preceding claims for high-voltage tests.

14. High-voltage testing system (13) according to Claim 13, **characterized in that**
the circuit arrangement (1) is arranged in a housing (15) which is designed to be filled with an insulation gas and has a connecting flange (17) for a test object (9).

## Revendications

1. Montage (1) pour des tests à haute tension, comprenant
- une source (3) de tension alternative
- et au moins deux branches (5, 7) de circuit, qui peuvent être reliées électriquement chacune à la source (3) de tension alternative,
- dans lequel au moyen d'une première branche (5) de circuit, une tension alternative électrique peut être appliquée à un échantillon (9),
**caractérisé en ce qu'**au moyen d'une deuxième branche (7) de circuit redressant une tension alternative, une tension continue électrique peut être appliquée à l'échantillon (9),
et le montage comprend en outre un premier interrupteur (S1_1), par lequel la première branche (5) du circuit peut être reliée électriquement à la source (3) de tension alternative, et un deuxième interrupteur (S1_2), par lequel la deuxième branche (7) du circuit peut être reliée électriquement à la source (3) de tension alternative.

2. Montage (1) suivant l'une des revendications précédentes, **caractérisé en ce que**
la source (3) de tension alternative a un transformateur réglable pour produire des tensions alternatives de valeur efficace différente.

3. Montage (1) suivant l'une des revendications précédentes, **caractérisé par**
au moins un étage de générateur de tension de choc pour la production d'une impulsion de haute tension pouvant être appliquée à un échantillon (9), dans lequel l'étage de générateur de tension de choc a un condensateur (C2, C3) accumulateur et un éclateur (Q1, Q2) de décharge du condensateur (C2, C3) accumulateur.

4. Montage (1) suivant la revendication 3,
**caractérisé par**
au moins deux étages de générateur de tension de choc montés en série.

5. Montage (1) suivant la revendication 3 ou 4,
**caractérisé en ce que**
un premier étage de générateur de tension de choc a un premier éclateur (Q1) pouvant être amorcé de façon active.

6. Montage (1) suivant l'une des revendications 3 à 5,
**caractérisé par**
un éclateur (Q3) de coupure est monté en parallèle à l'échantillon (9).

7. Montage (1) suivant la revendication 6,
**caractérisé en ce que**
l'éclateur (Q3) de coupure est constitué de manière à pouvoir être déclenché de façon active.

8. Montage (1) suivant l'une des revendications 3 à 7,
**caractérisé en ce que**
le au moins un étage de générateur de tension de choc est intégré à la deuxième branche (7) de circuit.

9. Montage (1) suivant l'une des revendications 3 à 8,
**caractérisé en ce que**
au moins un étage de générateur de tension de choc a un éclateur (Q1, Q2) ayant des électrodes d'éclateur, dont la distance entre les électrodes est réglable jusqu'à un contact entre les électrodes des éclateurs et/ou **en ce que** l'éclateur (Q1, Q2) d'au moins l'un des étages de générateur de tension de choc peut être shunté par une ligne de shuntage et par un interrupteur de shuntage.

10. Montage (1) suivant l'une des revendications précédentes, **caractérisé en ce que**
la première branche (5) de circuit comprend pour des mesures de décharge partielle un condensateur (C4) de couplage et un premier quadrupôle (X1) de découplage monté en aval de celui-ci.

11. Montage (1) suivant l'une des revendications précédentes, **caractérisé en ce que**
la deuxième branche (7) de circuit comprend pour élever la tension continue un élément de circuit de Villard ayant un condensateur (C1) de charge de Villard et une diode (D1) de Villard.

12. Montage (1) suivant la revendication 11,
**caractérisé en ce que**
la deuxième branche (7) de circuit a pour des mesures de décharge partielle un deuxième quadrupôle (X2) de découplage, qui peut être relié au condensateur (C1) de charge de Villard par un interrupteur (S2_1) de découplage.

13. Installation (13) de test de haute tension ayant un montage (1) suivant l'une des revendications précédentes pour des tests de haute tension.

14. Installation (13) de tests de haute tension ayant un montage (1) suivant la revendication 13,
**caractérisée en ce que**
le montage (1) est disposé dans un boîtier (15), qui est constitué pour être rempli d'un gaz isolant et qui a une bride (1) de connexion pour un échantillon (9).
